# EUROPEAN PATENT SPECIFICATION

(11) **EP 4 079 112 B1**
(45) Date of publication and mention of the grant of the patent: **02.12.2026**
(21) Application number: 20902666.5
(22) Date of filing: 17.12.2020
(51) Int. Cl.: H01Q 1/22, G06K 19/077, H01Q 1/38, H05K 3/10

(54) **METHOD FOR PRODUCING A CONDUCTIVE PATTERN ON A SUBSTRATE**
VERFAHREN ZUR HERSTELLUNG EINES LEITFÄHIGEN MUSTERS AUF EINEM SUBSTRAT
PROCÉDÉ DE PRODUCTION D'UN MOTIF CONDUCTEUR SUR UN SUBSTRAT

(30) Priority: 20.12.2019 SE 1951520
(43) Date of publication of application: 26.10.2022
(73) Proprietor: Digital Tags Finland Oy, 33800 Tampere (FI)
(72) Inventor: HUHTASALO, Lauri, 33200 Tampere (FI); BACKFOLK, Kaj, 53100 Villmanstrand (FI)
(74) Representative: Papula Oy
(86) International application number: PCT/IB2020/062113
(87) International publication number: WO 2021/124201

(56) References cited:
- WO-A1-2014/171995
- WO-A1-2014/171995
- US-A1- 2015 298 492
- US-A1- 2015 298 492
- US-A1- 2016 243 577
- US-A1- 2016 243 577
- US-A1- 2017 208 685
- US-A1- 2017 208 685
- US-A1- 2018 168 048
- US-A1- 2018 168 048

## Description

### Technical field

The present invention relates to a method for producing an electrically conductive pattern on a substrate and a method for producing an RFID tag.

### Prior art - Problem

It is known to form a conductive pattern on a substrate, wherein solid conductive particles are formed into a predetermined pattern on the substrate. Thereafter, the solid particles are heated by thermal heating, typically in an oven, wherein the solid particles reach a temperature above their characteristic melting point. The particles are then pressed in a nip such that the particles are flattened wherein the particles electrically connect to each other and thereby form the conductive pattern.

A drawback with this method is that not only the solid particles, but also the substrate absorbs heat during the heating process. This may cause problem, for example a fiber-based substrate will dry when heated. This will lead to unwanted dimensional changes of the substrate. Moreover, if heated to too high temperature, the fibers can start change color towards brown or even burn. In addition, the thermal heating has a relatively high energy consumption.

US 2016/243577 A1 discloses a method and an arrangement for producing an electrically conductive pattern on a surface.

US 2017/208685 A1 discloses a thermoplastic composition including a) a thermoplastic resin and b) a laser direct structuring (LDS) additive in an amount of at least 1 wt. % with respect to the weight of the total composition, wherein the LDS additive includes a mixed metal oxide including at least tin and a second metal selected from the group consisting of antimony, bismuth, aluminium and molybdenum, wherein the LDS additive includes at least 40 wt. % of tin and wherein the weight ratio of the second metal to tin is at least 0.02:1.

US 2018/168048 A1 discloses a method (200, 300, 500) for producing an electrically conductive pattern on substrate (202, 402), comprising: providing electrically conductive solid particles onto an area of the substrate in a predefined pattern (508), where the pattern (403) comprises a contact area (404B) for connecting to an electronic component and a conductive structure (404A) having at least a portion (414) adjacent to the contact area, heating the conductive particles to a temperature higher than a characteristic melting point of the particles to establish a melt (510), and pressing the melt against the substrate in a nip, the temperature of the contact portion of which being lower than the aforesaid characteristic melting point so as to solidify the particles into essentially electrically continuous layer within the contact area and within the conductive structure in accordance with the pattern (512), wherein the thermal masses of the contact area and the at least adjacent portion of the conductive structure are configured substantially equal.

WO 2014/171995 A1 discloses a method for fabricating metal structures in two or three dimensions, which includes providing a mixture of a polymer, a metal precursor and a solvent, and applying the mixture to a surface of a substrate, wherein the polymer comprises gelatin.

US 2015/298492 A1 discloses a method and a machine for decorating products, including a digital printing head for applying, on the surface of the products to be decorated, at least one layer of fluid adhesive material, elements for depositing granular materials on the layer of adhesive material, and elements for removing the excess granular materials.

### Object of invention

An object with the invention is to provide a method to produce an electrically conductive pattern on a substrate that at least partly solves the above-mentioned problem.

### Summary of the invention

The invention is a method for producing an electrically conductive pattern on a substrate, wherein the method comprising the steps of:
- forming an adhesive layer in a predetermined pattern on a substrate, made of at least one of a cellulose material and a polymer material,
- adding electrically conductive solid particles onto the adhesive layer, wherein the particles stick onto the adhesive,
- heating the solid particles with electromagnetic radiation wherein the wavelengths of the electromagnetic spectrum are in the range 600-1400 nm, preferably in the range 700-1200 nm, such that the temperature of the particles exceeding their characteristic melting point, and
- pressing the heated particles against the substrate in a nip, wherein the particles are flattened, such that the particles electrically connect to each other and thereby form the conductive pattern,
- at least one additional heating step in which the particles are heated to a temperature below the characteristic melting point, wherein the additional heating step is heating with infrared radiation heating wherein the wavelength of the IR source is from 1500 nm and above.

Moreover, the invention is a method for producing an RFID tag, wherein the method comprising the steps of:
- forming an adhesive layer in a predetermined pattern on a substrate made of at least one of a cellulose material and a polymer material,
- adding electrically conductive solid particles onto the adhesive layer, wherein the particles stick onto the adhesive,
- heating the solid particles with electromagnetic radiation wherein the wavelengths of the electromagnetic spectrum are in the range 600-1400 nm, preferably in the range 700-1200 nm, such that the temperature of the particles exceeding their characteristic melting point, and
- pressing the heated particles against the substrate in a nip, wherein the particles are flattened, such that the particles electrically connect to each other and thereby form an antenna, and
- attaching an integrated circuit (IC) onto the antenna, such that an electrical connection between the IC and the antenna is established, wherein the antenna and the IC form the RFID tag,
- at least one additional heating step in which the particles are heated to a temperature below the characteristic melting point, wherein the additional heating step is heating with infrared radiation heating wherein the wavelength of the IR source is from 1500 nm and above.

### Detailed description of the invention

The inventive method for producing an electrically conductive pattern on a substrate will hereinafter be described more in detail with reference to some preferred embodiments.

The method comprising a step of forming an adhesive layer in a predetermined pattern on a substrate. The adhesive pattern can be applied by any suitable method for applying an adhesive pattern onto a substrate e.g. inkjet, flexo printing, letterpress printing, gravure printing, screen printing, spraying, web coating, wheel applying, brushing or any other method capable of depositing an adhesive pattern on the substrate is included. The adhesive may be any suitable adhesive for the purpose. A preferred adhesive is an acrylic based adhesive e.g. styrene/acrylate, styrene/butadiene or PVAc emulsions. The adhesive could also be starch based adhesive such as modified starch.

The substrate may be a paper or paperboard material, since these cellulose materials have very good adhesive properties of the conductive pattern. Moreover, paper and paperboard are eco-friendly, since they are biodegradable and recyclable. A preferred substrate is a cellulose substrate with a grammage from 30 to 200 gsm. Moreover, the substrate may be a single or multiply substrate. Another suitable cellulose substrate is a substrate made of microfibrillated cellulose (MFC) or a film made of microfibrillated cellulose.

However, the skilled person realizes that other, nonconductive, substrates are possible such as polyester taffeta or nylon. These polymer substrates are especially suitable if the product will be used in a wet environment e.g. a care label in clothes which contain washing instructions. These polymers are highly sensitive to heat, so the invention is very suitable for these materials as well. The skilled person also realizes that the substrate may be made of a combination of a cellulose material and a polymer material.

The method further comprises the step of adding electrically conductive solid particles onto the adhesive layer pattern, wherein the particles stick onto the adhesive. The solid particles may be applied in several different ways and the invention is not limited to a specific application method. For example, the applying steps may be blowing the solid particles onto the adhesive, dipping the substrate onto a bed of particles wherein the particles stick onto the adhesive pattern or by electrostatic transferring.

The electrically conductive solid particles are preferably made of a solder material of a non-eutectic alloy. However, most preferred is an alloy comprising tin and bismuth or only tin. Tin and bismuth are lead-free and are therefore more environmentally friendly. Moreover, they have a relatively low melting temperature and relatively good electrical conductivity.

The method also comprising at least one step of heating. The heating is performed by heating the solid particles with electromagnetic radiation wherein the wavelengths of the electromagnetic spectrum are in the range 600-1400 nm, preferably in the range 700-1200 nm, such that the temperature of the particles exceeding their characteristic melting point.

The energy emission of the electromagnetic radiation is in the range 1.5-2.8 MW/µm m².

Tests have shown that electromagnetic radiation at these short wavelengths are very suitable for heating/melting the solid solder particles of a non-eutectic alloy. In this region the radiation excites combinations and overtones of molecular vibrations. This means that the molar absorptivity is typically small in this part of the electromagnetic spectrum with the consequence that many polymer compounds do not have a strong absorbance and thereby do not heat up easily when irradiated with such short electromagnetic radiation wavelengths. The electromagnetic radiation with these short wavelengths has the potential to selectively heat a material with a strong absorbance in this part of the spectrum and its inherent energy density would enable high speed, whilst the underlaying substrate will allow penetration of the radiation through it thus avoiding damage. The electromagnetic radiation having these short wavelengths is also known as Near Infrared or NIR. The electromagnetic radiation may be applied directly onto frontside of the substrate that faces against the solid particles or onto the backside of the substrate that faces away from the solid particles or simultaneously on both sides of the substrate.

Hence, paper, fiber-based substrates and most common plastic packaging do not significantly absorb radiation at these at these short wavelengths. This means that unnecessary heating of the substrates which indirectly causing negative effects to the substrates made of paper, paper board, polyester and nylon is very much decreased.

The method also comprises the step of pressing the heated particles against the substrate. The pressure is performed in a nip and the surface temperature of the nip is lower than the characteristic melting temperature of the particles. The pressure of the nip will make the particles flattened, such that the particles electrically connect to each other and thereby form a conductive pattern.

This pressure is preferably applied relatively soon after the radiation heating, wherein the particles still remain in almost melted state. Hereby, the previously melted material to solidify in the form an essentially continuous, electrically conductive pattern.

The nip may be a non-heated nip. However, preferably, the nip surface is heated into a temperature somewhat (such as 30-60°C) lower than the characteristic melting temperature. This ensures for example that the melt will not solidify prematurely, before it would become pressed against the substrate. The nip will cause the previously molten material of the originally solid electrically conductive particles to solidify again, but this time not in the form of separate particles but in the form of an essentially continuous, electrically conductive layer, arranged in the predetermined pattern.

The method involves one or several additional heating steps. These additional heating steps may be arranged before and/or after the electromagnetic radiation step with short wavelengths.

The additional heating step is an infrared radiation (IR) heating with a wavelength from 1500 nm and above. The IR source is preferably 2 x 2kW IR lamps or 4 x 2kW IR lamps. IR with a wavelength from 1500 nm and above after the step electromagnetic radiation with wavelengths the range 600-1400 nm.

The additional heating step may also be thermal heating in an oven. The temperature of the oven is below 200°C.

The additional heating steps may be favourable since a conductor can have geometries with various shapes and sizes. The combination of the different heating steps may all heat the different geometrical shapes differently. E.g. one heating method heats first the narrow shapes or edges of solid patterns, whereas some other heating method may first heat the centre of the solid pattern. Therefore, it may be beneficial to accompany the inventive electromagnetic radiation heating step (wavelengths 600-1400 nm) with IR and/or thermal heating to reach balanced and uniform heating profile of variable geometric shapes.

In a preferred embodiment of the invention the formed conductive pattern is an antenna, preferably an antenna for an RFID tag.

In another embodiment the invention comprises a method for producing an RFID tag. This embodiment the same as the embodiments above and, in addition, comprises the step of attaching an integrated circuit (IC) or microchip to the conductive pattern, i.e. the antenna, such that an electrical connection between the IC and the antenna is established, wherein the antenna and the IC form the RFID tag.

The attachment of the IC to the antenna may be performed in various way. In a first embodiment the IC is attached to the antenna by applying an adhesive between the IC and the antenna pad area and pressing the IC onto the RFID antenna. In a second embodiment the IC is attached via soldering.

Some benefits with the method in accordance with the invention in comparison to prior art:
- The substrate will absorb less heat which means less risk of a damaged substrate.
- The energy consumption will be reduced since the heat is directed where it is needed.
- Even if additional heat is used, the energy consumption will be reduced thanks to the inventive heating step.
- The inventive method enables that heat sensitive substrates can be used.
- A substrate made of cellulose and/or polymer do not significantly absorb radiation at these short wavelengths. This means that unnecessary heating of the substrate is very much decreased, since it has been showed that heating and cooling of the substrate increases stresses in the substrate which might lead to cracks etc.

In the foregoing, the invention has been described based on some preferred embodiments. However, a person skilled in the art realises that additional embodiments and variants are possible within the scope of the following claims.

For example, the invention is not only applicable for producing an antenna for an RFID tag. The skilled person realizes that the inventive method is applicable in producing other conductive patterns such as e.g. printed wiring, conductor for flexible batteries, displays, sensors, heaters or similar.

## Claims

1. Method for producing an electrically conductive pattern on a substrate, wherein the method comprising the steps of:
- forming an adhesive layer in a predetermined pattern on a substrate made of at least one of a cellulose material and a polymer material,
- adding electrically conductive solid particles onto the adhesive layer, wherein the particles stick onto the adhesive,
- heating the solid particles with electromagnetic radiation wherein the wavelengths of the electromagnetic spectrum are in the range 600-1400 nm, preferably in the range 700-1200 nm, such that the temperature of the particles exceeding their characteristic melting point, and
- pressing the heated particles against the substrate in a nip, wherein the particles are flattened, such that the particles electrically connect to each other and thereby form the conductive pattern, and wherein the method is **characterized in that** it further comprises the steps of:
- at least one additional heating step in which the particles are heated to a temperature below the characteristic melting point, wherein the additional heating step is heating with infrared radiation heating wherein the wavelength of the IR source is from 1500 nm and above.

2. Method according to claim 1, wherein the additional heating step is thermal heating in an oven, wherein the temperature of the oven is below 200°C.

3. Method according to any of claims 1-2, wherein the energy emission of the electromagnetic radiation is in the range 1.5-2.8 MW/µm m².

4. Method according to any of claims 1-3, wherein the solid particles are made of a eutectic alloy.

5. Method according to claim 4, wherein the eutectic alloy comprises tin, preferably tin and bismuth.

6. Method according to any of claims 1-5, wherein substrate is made of paper or paper board material.

7. Method according to any of claims 1-5, wherein the substrate is made of polyester or nylon.

8. Method according any of claims 1-7, wherein the conductive pattern is an antenna.

9. Method according to claim 8, wherein the method further comprising the step of attaching an integrated circuit (IC) onto the antenna, such that an electrical connection between the IC and the antenna is established, wherein the antenna and the IC form an RFID tag.

10. Method for producing an RFID tag, wherein the method comprising the steps of:
- forming an adhesive layer in a predetermined pattern on a substrate made of at least one of a cellulose material and a polymer material,
- adding electrically conductive solid particles onto the adhesive layer, wherein the particles stick onto the adhesive, and wherein the method is **characterized in that** it further comprises the steps of:
- heating the solid particles with electromagnetic radiation wherein the wavelengths of the electromagnetic spectrum are in the range 600-1400 nm, preferably in the range 700-1200 nm, such that the temperature of the particles exceeding their characteristic melting point, and
- pressing the heated particles against the substrate in a nip, wherein the particles are flattened, such that the particles electrically connect to each other and thereby form an antenna, and
- attaching an integrated circuit (IC) onto the antenna, such that an electrical connection between the IC and the antenna is established, wherein the antenna and the IC form the RFID tag, and
- at least one additional heating step in which the particles are heated to a temperature below the characteristic melting point, wherein the additional heating step is heating with infrared radiation heating wherein the wavelength of the IR source is from 1500 nm and above.

11. Method according to claim 10, wherein the integrated circuit (IC) is attached by gluing and pressing the IC onto the antenna.

12. Method according to claim 10, wherein the integrated circuit (IC) is attached by soldering.

## Patentansprüche

1. Verfahren zur Herstellung eines elektrisch leitfähigen Musters auf einem Substrat, wobei das Verfahren die folgenden Schritte umfasst:
- Bilden einer Klebeschicht in einem vorbestimmten Muster auf einem Substrat, das mindestens aus einem von einem Zellulosematerial und einem Polymermaterial besteht,
- Hinzufügen elektrisch leitfähiger Feststoffpartikel auf die Klebeschicht, wobei die Partikel auf dem Kleber haften,
- Erhitzen der Feststoffpartikel mit elektromagnetischer Strahlung, wobei die Wellenlängen des elektromagnetischen Spektrums in dem Bereich 600-1400 nm, bevorzugt in dem Bereich 700-1200 nm, liegen, sodass die Temperatur der Partikel ihren charakteristischen Schmelzpunkt überschreitet, und
- Pressen der erhitzten Partikel in einem Spalt gegen das Substrat, wobei die Partikel abgeflacht werden, sodass die Partikel elektrisch miteinander verbunden werden und dadurch das leitfähige Muster bilden, und wobei das Verfahren **dadurch gekennzeichnet ist, dass** es weiter die folgenden Schritte umfasst:
- mindestens einen zusätzlichen Erhitzungsschritt, bei dem die Partikel auf eine Temperatur unterhalb des charakteristischen Schmelzpunkts erhitzt werden, wobei der zusätzliche Erhitzungsschritt eine Erhitzung mittels Infrarotstrahlungs-Erhitzung ist, wobei die Wellenlänge der IR-Quelle ab 1500 nm und darüber liegt.

2. Verfahren nach Anspruch 1, wobei der zusätzliche Erhitzungsschritt das thermische Erhitzen in einem Ofen ist, wobei die Temperatur des Ofens unter 200 °C liegt.

3. Verfahren nach einem der Ansprüche 1-2, wobei die Energieemission der elektromagnetischen Strahlung in dem Bereich 1,5-2,8 MW/µm m² liegt.

4. Verfahren nach einem der Ansprüche 1-3, wobei die Feststoffpartikel aus einer eutektischen Legierung bestehen.

5. Verfahren nach Anspruch 4, wobei die eutektische Legierung Zinn, bevorzugt Zinn und Bismut, umfasst.

6. Verfahren nach einem der Ansprüche 1 bis 5, wobei das Substrat aus Papier oder Kartonmaterial besteht.

7. Verfahren nach einem der Ansprüche 1 bis 5, wobei das Substrat aus Polyester oder Nylon besteht.

8. Verfahren nach einem der Ansprüche 1 bis 7, wobei das leitfähige Muster eine Antenne ist.

9. Verfahren nach Anspruch 8, wobei das Verfahren weiter den Schritt des Befestigens einer integrierten Schaltung (IC) an der Antenne umfasst, sodass eine elektrische Verbindung zwischen der IC und der Antenne hergestellt wird, wobei die Antenne und die IC ein RFID-Tag bilden.

10. Verfahren zur Herstellung eines RFID-Tags, wobei das Verfahren die folgenden Schritte umfasst:
- Bilden einer Klebeschicht in einem vorbestimmten Muster auf einem Substrat, das mindestens aus einem von einem Zellulosematerial und einem Polymermaterial besteht,
- Hinzufügen elektrisch leitfähiger Feststoffpartikel auf die Klebeschicht, wobei die Partikel auf dem Klebstoff haften, und wobei das Verfahren **dadurch gekennzeichnet ist, dass** es weiter die folgenden Schritte umfasst:
- Erhitzen der Feststoffpartikel mit elektromagnetischer Strahlung, wobei die Wellenlängen des elektromagnetischen Spektrums in dem Bereich 600-1400 nm, bevorzugt in dem Bereich 700-1200 nm, liegen, sodass die Temperatur der Partikel ihren charakteristischen Schmelzpunkt überschreitet, und
- Pressen der erhitzten Partikel in einem Spalt gegen das Substrat, wobei die Partikel abgeflacht werden, sodass die Partikel elektrisch miteinander verbunden werden und dadurch eine Antenne bilden, und
- Befestigen einer integrierten Schaltung (IC) an der Antenne, sodass eine elektrische Verbindung zwischen der IC und der Antenne hergestellt wird, wobei die Antenne und die IC das RFID-Tag bilden, und
- mindestens einen zusätzlichen Erhitzungsschritt, bei dem die Partikel auf eine Temperatur unterhalb des charakteristischen Schmelzpunkts erhitzt werden, wobei der zusätzliche Erhitzungsschritt eine Erhitzung mittels Infrarotstrahlungs-Erhitzung ist, wobei die Wellenlänge der IR-Quelle ab 1500 nm und darüber liegt.

11. Verfahren nach Anspruch 10, wobei die integrierte Schaltung (IC) durch Kleben und Pressen der IC an der Antenne befestigt wird.

12. Verfahren nach Anspruch 10, wobei die integrierte Schaltung (IC) durch Löten der IC an der Antenne befestigt wird.

## Revendications

1. Procédé de production d'un motif électriquement conducteur sur un substrat, dans lequel le procédé comprend les étapes suivantes :
- la formation d'une couche adhésive dans un motif prédéterminé sur un substrat composé d'au moins l'un parmi un matériau cellulosique et un matériau polymère,
- l'ajout de particules solides électriquement conductrices sur la couche adhésive, dans lequel les particules se collent à l'adhésif,
- le chauffage des particules solides par rayonnement électromagnétique dans lequel les longueurs d'onde du spectre électromagnétique sont comprises dans la plage de 600 à 1400 nm, préférablement dans la plage de 700 à 1200 nm, de sorte que la température des particules dépasse leur point de fusion caractéristique, et
- le pressage des particules chauffées contre le substrat dans une zone de contact, dans lequel les particules sont aplaties, de sorte que les particules soient électriquement connectées entre elles et forment ainsi le motif conducteur, et dans lequel le procédé est **caractérisé en ce qu'**il comprend en outre les étapes suivantes :
- au moins une étape de chauffage supplémentaire dans laquelle les particules sont chauffées à une température inférieure au point de fusion caractéristique, dans lequel l'étape de chauffage supplémentaire est un chauffage par rayonnement infrarouge dans lequel la longueur d'onde de la source IR est de 1500 nm et plus.

2. Procédé selon la revendication 1, dans lequel l'étape de chauffage supplémentaire est un chauffage thermique dans un four, dans lequel la température du four est inférieure à 200 °C.

3. Procédé selon l'une quelconque des revendications 1 à 2, dans lequel l'émission d'énergie du rayonnement électromagnétique est comprise dans la plage de 1,5 à 2,8 MW/µm m².

4. Procédé selon l'une quelconque des revendications 1 à 3, dans lequel les particules solides sont composées d'un alliage eutectique.

5. Procédé selon la revendication 4, dans lequel l'alliage eutectique comprend de l'étain, de préférence de l'étain et du bismuth.

6. Procédé selon l'une quelconque des revendications 1 à 5, dans lequel le substrat est composé d'un matériau de type papier ou carton.

7. Procédé selon l'une quelconque des revendications 1 à 5, dans lequel le substrat est composé de polyester ou de nylon.

8. Procédé selon l'une quelconque des revendications 1 à 7, dans lequel le motif conducteur est une antenne.

9. Procédé selon la revendication 8, dans lequel le procédé comprend en outre l'étape de fixation d'un circuit intégré (IC) sur l'antenne, de sorte qu'une connexion électrique entre l'IC et l'antenne soit établie, dans lequel l'antenne et l'IC forment une étiquette RFID.

10. Procédé de production d'une étiquette RFID, dans lequel le procédé comprend les étapes suivantes :
- la formation d'une couche adhésive dans un motif prédéterminé sur un substrat composé d'au moins l'un parmi un matériau cellulosique et un matériau polymère,
- l'ajout de particules solides électriquement conductrices sur la couche adhésive, dans lequel les particules se collent à l'adhésif, et dans lequel le procédé est **caractérisé en ce qu'**il comprend en outre les étapes suivantes :
- le chauffage des particules solides par rayonnement électromagnétique dans lequel les longueurs d'onde du spectre électromagnétique sont comprises dans la plage de 600 à 1400 nm, préférablement dans la plage de 700 à 1200 nm, de sorte que la température des particules dépasse leur point de fusion caractéristique, et
- le pressage des particules chauffées contre le substrat dans une zone de contact, dans lequel les particules sont aplaties, de sorte que les particules soient électriquement connectées entre elles et forment ainsi une antenne, et
- la fixation d'un circuit intégré (IC) sur l'antenne, de sorte qu'une connexion électrique entre l'IC et l'antenne soit établie, dans lequel l'antenne et l'IC forment l'étiquette RFID, et
- au moins une étape de chauffage supplémentaire dans laquelle les particules sont chauffées à une température inférieure au point de fusion caractéristique, dans lequel l'étape de chauffage supplémentaire est un chauffage par rayonnement infrarouge dans lequel la longueur d'onde de la source IR est de 1500 nm et plus.

11. Procédé selon la revendication 10, dans lequel le circuit intégré (IC) est fixé par collage et par pressage du IC sur l'antenne.

12. Procédé selon la revendication 10, dans lequel le circuit intégré (IC) est fixé par brasage.
